# EUROPÄISCHE PATENTSCHRIFT

(11) **EP 0 534 905 B1**
(45) Veröffentlichungstag und Bekanntmachung des Hinweises auf die Patenterteilung: **17.04.1996**
(21) Anmeldenummer: 92810721.8
(22) Anmeldetag: 21.09.1992
(51) Int. Cl.: C23C 30/00, C23C 14/06, B23B 27/14, B23C 5/00

(54) **Werkzeuge für die Zerspannung von Werkstoffen**
Tools for machining materials
Outils pour l'usinage de matériaux

(30) Priorität: 23.09.1991 CH 2893/91
(43) Veröffentlichungstag der Anmeldung: 31.03.1993
(73) Patentinhaber: VILAB AG, CH-3014 Bern (CH)
(72) Erfinder: Rechberger, Johann, CH-3052 Zollikofen (CH); Dubach, Roland, CH-1338 Ballaigues (CH)
(74) Vertreter: Fischer, Franz Joseph

(56) Entgegenhaltungen:
- EP-A- 0 432 090
- WO-A-87/06273
- DE-A- 2 415 255
- US-A- 4 820 591
- US-A- 5 002 798
- DATABASE WPI Week 8007, 30. Juli 1979 Derwent Publications Ltd., London, GB; AN 80-12251C & SU-A-664984
- Database WPI, Week 8039, 15. Februar 1980, Derwent Publications Ltd., London, GB, AN 80-69308C & SU-A-715 631

## Beschreibung

Die vorliegende Erfindung betrifft ein Verfahren zur Herstellung von Werkzeugen für die Zerspanung von Werkstoffen. Die Werkzeuge besitzen Oberflächen-Beschichtungen, die aus mindestens einer Verbindung aus mindestens einem der Hauptelemente der 6. Gruppe des periodischen Systems: O, S, Se, Te einerseits, und aus mindestens einem der Nebengruppenelemente der 5. und 6. Gruppe des periodischen Systems: V, Nb, Ta, Cr, Mo, W, andererseits, bestehen. Die Beschichtungsmaterialien sind bekannte Schmier- und Gleitstoffe, welche nach dem PVD (Physical Vapor Deposition)-System abgeschieden werden. Die erfindungsgemässen Werkzeuge sind den bekannten, derartigen Werkzeugen, welche mit Hartstoffen beschichtet sind, überlegen und können überdies kostengünstiger hergestellt werden.

Es ist heute allgemein bekannt, dass harte Schichten auf Basis von Carbiden, Nitriden, Carbonitriden, Boriden, Siliciden und Oxiden von Elementen der 3. bis 8. Gruppe des periodischen Systems, verschleissfeste Eigenschaften besitzen. Diese Schichten weisen sehr hohe Härtewerte auf, im Bereich von 1'500 HV bis 4'000 HV und mehr.

Eines der weltweit bekanntesten Anwendungsgebiete ist das Beschichten von Zerspanungswerkzeugen aus Hartmetall, Schnellarbeitsstahl und Werkzeugstahl mit Hartstoffen, z.B. TiC, TiN, TiNC usw., wobei wesentliche Standzeitverbesserungen erzielt werden. Als Zerspanungswerkzeuge können unter anderem Wendeschneidplatten, Fräser, Reibahlen, Bohrer, usw. als Beispiele genannt werden. Die Dicke dieser Schichten oder auch der Schichtkombinationen liegt vorzugsweise zwischen 2 und 5 µm. Sie ist durch die Duktilität und Haftfestigkeit der Schicht auf dem Substratmaterial begrenzt. Die Wirkung der Schicht wird auf die hohe Härte und Verschleissfestigkeit zurückgeführt, indem bei der Zerspanung bei hohem Druck und teilweise hohen Temperaturen ein Metall-Metall-Kontakt vermieden werden kann, und daher keine örtlichen Verschweissungen auftreten.

Die Praxis hat gezeigt, dass bei gewissen Legierungen und Stahlsorten diese mit Hartstoffen beschichteten Werkzeuge nicht die erhoffte Zerspanungsleistung bringen. Solche zu bearbeitende Legierungen sind z.B.: Aluminiumlegierungen, Titanlegierungen sowie Nickellegierungen. Aus diesem Grund werden heute zur Zerspanung oben genannter Werkstoffe häufig unbeschichtete- oder Hartmetallwerkzeuge eingesetzt.

Es war Aufgabe der vorliegenden Erfindung, Alternativen zu den oben erwähnten Werkzeugen für die Zerspanung von Werkstoffen bereitzustellen, welche frei von den oben genannten Nachteilen sind und überdies kostengünstiger und einfacher herstellbar sind.

Ueberraschenderweise wurde nun gefunden, dass die Beschichtung von Werkzeugen für-die Zerspanung von Werkstoffen mit anorganischen Verbindungen, welche als Schmier- und Gleitstoffe bekannt sind, wie Molybdändisulfid und dergleichen zu Werkzeugen führt, welche den mit Hartstoff beschichteten Werkzeugen nicht nur äquivalent, sondern häufig sogar überlegen sind.

Es war bekannt, Maschinenteile wie Kugellager und dergleichen zwecks Schmierung mit Molybdändisulfid zu beschichten. Heutzutage wird diese Beschichtung ebenfalls vorwiegend durch PVD durchgeführt. Das Hauptanwendungsgebiet liegt heute überall dort, wo Schmier- und Gleitstoffe benutzt werden können, aber wegen den äusseren Bedingungen wie hohen Temperaturen, Vakuum oder Hochvakuum, keine traditionellen Schmiermittel auf Oel- oder Fettbasis verwendet werden können. Im SU-Patent 71 56 31 sind ebenfalls Stahlwerkzeuge beschrieben, deren Verschleissfestigkeit erhöht wurde, indem sie durch Aetzen vorbehandelt wurden und man anschliessend in die Oberfläche Molybdändisulfid eindiffundieren liess. Danach wurde noch gewaschen, getrocknet und tiefgekühlt. Erfindungsgemäss wurde jedoch gefunden, dass durch einfacheres Beschichtungsverfahren ohne Aetzverfahren mit umweltschädlichen Chemikalien und ohne energieintensive Tiefkühlung Werkzeuge für die zerspanende Bearbeitung von Werkstoffen erhalten werden können. Solche Werkzeuge konnten bisher nur durch Hartstoffbeschichtungen erhalten werden. Es war höchst überraschend, dass durch die erfindungsgemässen Beschichtungen mit Härten von weniger als 400 Vickers derartige Werkzeuge erhalten werden konnten, welche den traditionellen Werkzeugen, deren Beschichtungen Härten von 1'500 Vickers und mehr aufweisen, überlegen sind.

Gegenstand der vorliegenden Erfindung ist demzufolge ein Verfahren, wie in Anspruch 1 beansprucht, zur Herstellung derartiger Werkzeuge das dadurch gekennzeichnet ist, dass ein Werkzeug, vorzugsweise aus Stahl mit oder ohne Hartstoffbeschichtung, mittels des PVD-Verfahrens mit mindestens einer verbindung beschichtet wird, die aus mindestens einem Element der Gruppe O, S, Se, Te einerseits, und aus mindestens einem Element der Gruppe V, Nb, Ta, Cr, Mo und W andererseits, besteht. Vorteilhafte Ausführungsformen des Verfahrens sind in den Ansprüchen 2 bis 4 beansprucht.

Beansprucht werden ebenfalls die durch das erfindungsgemässe Verfahren hergestellten Werkzeuge nach Anspruch 5 und deren vorteilhafte Ausführung nach Anspruch 6 sowie ihre Verwendung gemäß Anspruch 7 für die zerspanende Bearbeitung von Werkstoffen. Als Verbindungen zur PVD-Beschichtung kommen in Frage: MoS₂, NbS₂, TaS₂, WS₂, MoSe₂, NbSe₂, TaSe₂, WSe₂, MoTe₂, NbTe₂, TaTe₂ und WTe₂, oder Mischverbindungen davon.

Für die Beschichtung der Werkzeuge, insbesondere Wendeschneidplatten, Fräser, Reibahlen und Bohrer gelangt vorzugsweise Molybdändisulfid zum Einsatz, welches als Schmierund Gleitstoff bekannt ist. Molybdändisulfid ist mit einer Mohs'schen Härte von 1 - 2 ein sehr weicher Stoff und weist einen sehr niedrigen Reibungskoeffizienten auf, der von den Umgebungsbedingungen abhängig ist: Im Vakuum beträgt er 0,01 - 0,04, bei trockener Luft 0,01 - 0,04, bei feuchter Luft 0,2 - 0,3 (relative Luftfeuchtigkeit 50 %). Im Gegensatz zu den Hartstoffschichten ist die funktionelle Schichtdicke sehr gering und liegt im Bereich von 0,1 - 1 µm. Überraschenderweise beträgt die Lebensdauer der erfindungsgemässen Werkzeuge für die zerspanende Bearbeitung bei vielen Anwendungen ein vielfaches von derjenigen der bekannten Werkzeuge aus Hartmetall oder mit Hartstoffbeschichtung. Die Erfindung verringert somit nicht nur den Materialverbrauch, sondern ermöglicht auch, dass automatisch gesteuerte Bearbeitungsvorgänge weniger unterbrochen werden müssen, um abgenützte Werkzeuge zu ersetzen, was die Produktivität steigert.

Zur Herstellung der erfindungsgemässen Werkzeuge zur Zerspanung von Werkstoffen werden die Werkzeuge normalerweise aus Stahl wie beispielsweise HSS-Stahl hergestellt und anschliessend durch das PVD(Physical Vapor Deposition)-Verfahren mit MoS₂ beschichtet. Bei der physikalischen Abscheidung PVD werden bei relativ tiefen Prozesstemperaturen, unter 550°C durch Kathodenzerstäubung dünne Schichten aufgetragen. Das Verfahren bewirkt keine Deformation am Werkzeug, was eine Nachbehandlung des Werkzeuges erübrigt. Besonders bewährt für die Abscheidung von MoS₂-Schichten und dergleichen bei der Herstellung der erfindungsgemässen Werkzeuge hat sich eine Anlage vom Typ "Closed Field Unbalanced Magnetron". Damit kann bei tiefem Gasdruck ein hoher Ionisierungsgrad erzielt werden, was zur Ausbildung von kompakten Schichten mit guter Haftung führt. Auch lässt sich die Schichtzusammenseztung mit diesem mehrfach magnetischen System optimal steuern und kontrollieren.

Die nachstehenden Beispiele sollen die Erfindung näher erläutern, ohne dass die Definition der Erfindung eine Einschränkung erfahren soll. Der Vergleich von Werkzeugen gemäss der Erfindung mit entsprechenden Werkzeugen aus Hartmetall bringt die überraschende Überlegenheit der erfindungsgemässen Werkzeuge zur Geltung.

In den nachstehenden Beispielen 1 und 2 wurde jeweils ein Werkstück aus der angegebenen Aluminium-Knetlegierung mit einem erfindungsgemässen MoS₂-beschichteten Fräser bearbeitet. Zum Vergleich wurde der gleiche Arbeitsgang mit einem konventionellen Werkzeug aus Hartmetall wiederholt.

### Beispiel 1

| | | |
|---|---|---|
| Legierung: | Anticorodal | 112 |
| | Werkstoffnr. | 3.2315 |

| Arbeitsbedingungen | Hartmetall | Schnellstahl MoS₂-beschichtet |
|---|---|---|
| Vorschub | 2'300 mm/min | 5'000 mm/min |
| Drehzahl | 10'000 U/min | 10'000 U/min |

| | | |
|---|---|---|
| Fräserdurchmesser : 8 mm | Nutgeometrie: | Breite = 2 mm |
| | | Tiefe = 8 mm |

### Beispiel 2

| | | |
|---|---|---|
| Legierung: | Anticorodal | 112 |
| | Werkstoffnr. | 3.2315 |

| Arbeitsbedingungen | Hartmetall | Schnellstahl MoS₂-beschichtet |
|---|---|---|
| Vorschub | 2'100 mm/min | 5'000 mm/min |
| Drehzahl | 12'000 U/min | 11'300 U/min |

| | | |
|---|---|---|
| Fräserdurchmesser: 8 mm | Nutgeometrie: | Breite = 8 mm |
| | | Tiefe = 2 mm |

### Beispiel 3

Es wurde ein Werkstück aus der Aluminium-Knetlegierung Anticorodal 112 mit einem erfindungsgemässen MoS₂-beschichteten HSS-Fräser bearbeitet. Zum Vergleich wurde der gleiche Arbeitsgang mit einem entsprechenden Werkzeug wiederholt, wobei das Werkzeug einmal nicht und das andere Mal mit TiN beschichtet war. Das Ergebnis zeigte, dass die Rauhigkeit der Oberfläche des mit dem MoS₂-beschichteten Fräser bearbeiteten Werkstückes die geringste war

| | | |
|---|---|---|
| Legierung: | Anticorodal | 112 |
| | Werkstoffnr. | 3.2315 |

| | | |
|---|---|---|
| Arbeitsbedingungen: | Werkzeug HSS | |
| | Vorschub: | 1'075 mm/min |
| | Drehzahl: | 4'000 U/min |
| | Geometrie: | Breite 6 mm, Tiefe 16 mm |
| | Durchmesser: | 10 mm |

Rauhigkeit nach einem Fräsweg von 15 Metern:

| | |
|---|---|
| HSS ohne MoS₂: | Rₐ = 5 - 6 µm |
| mit TiN : | Rₐ = 4 - 6 µm |
| mit MoS₂ : | Rₐ < 2 µm |

Aus den obigen Beispielen geht eindeutig hervor, dass durch die erfindungsgemässen Werkzeuge eine Leistungssteigerung bewirkt wurde. Diese ist für den Fachmann überraschend, da die Leistungssteigerungen für derartige Werkzeuge in der Vergangenheit immer der Auftragung von noch härteren Schichten zugeschrieben wurden.

### Beispiel 4

Ein Werkstück aus HSS-Stahl wurde mittels PVD mit MoS₂ beschichtet, wobei ein Werkzeug erhalten wurde, wie es in den obigen Beispielen zum Einsatz gelangte. Hierzu wurde eine Anlage des "Closed Field Unbalanced Magnetron"-Typs verwendet, welche einen symmetrischen vertikalen 4-Magnetron-Reaktor mit 250 l Innenvolumen aufwies. Als Prozessgas gelangte Argon unter einem Druck von 0,27 Pa (2·10⁻³ Torr) zur Anwendung. Die totale Magnetron-Leistung betrug 4 kW. Als Target wurde reines MoS₂ eingesetzt. Die Substrattemperatur betrug <250 °C und die Substrat Bias Spannung <50 V DC.

Die Molybdändisulfidschichten weisen im Vergleich zu den Hartstoffschichten gemäss dem Stand der Technik folgende abweichende Eigenschaften auf:

| | | |
|---|---|---|
| | MoS₂ | Hartstoffschicht |
| Härte | 1-2 Mohs | > 1500 Vickers |
| Schichtdicke | 0,4-1 µm | 3-5 µm |

Der Reibungskoeffizient bei 50 % relativer Luftfeuchtigkeit weist hingegen ungefähr den gleichen Wert auf: MoS₂: 0,2 - 0,3; Hartstoffschicht (Tic): 0,25.

Signifikant fiel ebenfalls ein Vergleich von zerspanenden Werkzeugen bei der Bearbeitung einer Platinlegierung aus:

Bei der Bearbeitung mit einem Werkzeug mit HartstoffBeschichtung wurde eine Schneidgeschwindigkeit von 30 m/min und ein Vorschub von 144 mm/min erzielt. Das Werkzeug musste dabei schon nach 3 Arbeitsgängen nachgeschliffen werden. Bei der Verwendung eines erfindungsgemässen Werkzeuges mit einer Molybdändisulfidbeschichtung konnte eine Schneidgeschwindigkeit von 94 m/min und ein Vorschub von 1′000 mm/min erzielt werden, wobei das Werkzeug auch nach zehn Arbeitsgängen unverändert weiterverwendet werden konnte.

In der nachstehenden Tabelle sind Leistungsdaten für das Umfangfräsen (unter Kühlung) von Aluminiumlegierungen (niedriger Si-Gehalt) mit typischen Vertretern von erfindungsgemässen Werkzeugen angegeben, nämlich für Nutenfräser F 1332 (Usines Métallurgiques de Vallorbe CH-1337 Vallorbe, Schweiz) mit verschiedenen Fräserdurchmessern D. Die dabei vorgesehene Schnittiefe beträgt D x 0,25D.

| **Schnittdaten für Nutenfräser beim Umfangfräsen (Dx0,25D)** | | | | |
|---|---|---|---|---|
| **Z** | **D** | **Vc (m/min)** | **n (tr/min)** | **Vf (mm/min)** |
| 3 | 6 | 150-230 | 7950-12200 | 3100-4800 |
| 3 | 8 | 170-250 | 6750-7950 | 3500-5300 |
| 3 | 10 | 220-330 | 7000-10500 | 4200-6800 |
| 3 | 12 | 250-386 | 6600-10200 | 4250-7400 |
| 3 | 14 | 250-386 | 5700-8800 | 5100-7900 |
| 3 | 16 | 250-386 | 4950-7650 | 5150-7950 |
| 3 | 18 | 250-386 | 4400-6800 | 5100-7600 |
| 3 | 20 | 250-386 | 3950-6100 | 5200-8000 |
| 3 | 25 | 250-386 | 3200-4600 | 5200-8000 |
| 3 | 32 | 250-386 | 2500-3800 | 5200-7900 |
| 3 | 40 | 250-386 | 2000-3000 | 5200-7900 |

- Z =: Zähnezahl
- D =: Fräserdurchmesser
- Vc=: Schnittgeschwindigkeit
- n =: Drehzahl
- Vf=: Vorschub

## Patentansprüche

1. Verfahren zur Herstellung eines Werkzeuges für die zerspanende Bearbeitung von Werkstoffen, dadurch gekennzeichnet, dass ein Werkzeug mittels des PVD-Verfahrens mit mindestens einer Verbindung beschichtet wird, die aus mindestens einem Element der Gruppe 0, S, Se, Te einerseits, und aus mindestens einem Element der Gruppe V, Nb, Ta, Cr, Mo und W andererseits, besteht.

2. Verfahren nach Anspruch 1, dadurch gekennzeichnet, dass das Werkzeug ein Werkzeug aus Stahl mit oder ohne Hartstoffbeschichtung ist.

3. Verfahren nach Anspruch 1 oder 2, dadurch gekennzeichnet, dass eine Schicht aus Molybdändisulfid aufgetragen wird.

4. Verfahren nach Anspruch 1 oder 2, dadurch gekennzeichnet, dass eine Schicht aus mindestens einer Verbindung der folgenden Gruppen MoSe₂, Nbse₂, TaSe₂, WSe₂, NbS₂, TaS₂, WS₂, MoTe₂, NbTe₂, TaTe₂ und WTe₂ aufgetragen wird.

5. Werkzeuge für die zerspanende Bearbeitung von Werkstoffen erhalten nach dem Verfahren nach einem der Ansprüche 1 bis 4.

6. Werkzeuge nach Anspruch 5, erhalten nach dem Verfahren nach Anspruch 3.

7. Verwendung eines Werkzeuges nach einem der Ansprüche 3 bis 6 für die Bearbeitung von Werkstoffen aus der Gruppe Aluminiumlegierungen, Titanlegierungen, Platin oder seine Legierungen und Kupferlegierungen.

## Claims

1. Method of producing a tool for the metal-cutting machining of materials, characterized in that a tool is coated with at least one compound by means of physical vapour deposition (PVD), the compound comprising at least one element of the group O, S, Se, Te on the one hand, and, on the other hand, at least one element of the Group V, Nb, Ta, Cr, Mo and W.

2. Method according to claim 1, characterized in that the tool is a tool of steel with or without hard material coating.

3. Method according to claim 1 or 2, characterized in that a coating of molybdenum disulfide is applied.

4. Method according to claim 1 or 2, characterized in that a coating of at least one compound of the following groups is applied MoSe₂, NbSe₂, TaSe₂, WSe₂, NbS₂, TaS₂, WS₂, MoTe₂, NbTe₂, TaTe₂ and WTe₂.

5. Tools for the metal-cutting machining of materials obtained according to the method of one of the claims 1 to 4.

6. Tools according to claim 5 obtained according to the method of claim 3.

7. Use of a tool according to one of the claims 3 to 6 for the machining of materials of the group aluminium alloys, titanium alloys, platinum or alloys thereof, and copper alloys.

## Revendications

1. Procédé de fabrication d'un outil pour le traitement d'usinage de matériaux, caractérisé en ce que, au moyen du procédé PVD (Physical Vapor Deposition) on applique sur un outil au moins une couche, qui se compose d'au moins un élément du groupe O, S, Se, Te, d'une part, et d'au moins un élément du groupe V, Nb, Ta, Cr, Mo et W, d'autre part.

2. Procédé selon la revendication 1, caractérisé en ce que l'outil est un outil en acier avec ou sans couche dure.

3. Procédé selon la revendication 1 ou la revendication 2, caractérisé en ce qu'on applique une couche de bisulfure de molybdène.

4. Procédé selon la revendication 1 ou la revendication 2, caractérisé en ce qu'on applique au moins une couche d'un composé des groupes suivantes MoSe₂, NbSe₂, TaSe₂, WSe₂, NbS₂, TaS₂, WS₂, MoTe₂, NbTe₂, TaTe₂ et WTe₂.

5. Outil pour le traitement d'usinage de matériaux obtenus selon le procédé selon l'une des revendications 1 à 4.

6. Outil selon la revendication 5 obtenu selon le procédé selon la revendication 3.

7. Utilisation d'un outil selon l'une des revendications 3 à 6 pour le traitement de métaux du groupe des alliages de l'aluminium, des alliages du titane, du platine ou de ses alliages et des alliages du cuivre.
